# EUROPEAN PATENT APPLICATION

(11) **EP 0 732 737 A2**
(43) Date of publication of application: **18.09.1996**
(21) Application number: 96103952.6
(22) Date of filing: 13.03.1996
(51) Int. Cl.: H01L 21/76

(54) **Composite semiconductor substrate and fabrication method thereof**

(30) Priority: 13.03.1995 JP 52638/95
(71) Applicant: NEC CORPORATION, Tokyo (JP)
(72) Inventor: Kikuchi, Hiroaki, c/o NEC Corporation, Tokyo (JP)
(74) Representative: VOSSIUS & PARTNER

(57) **Abstract**

A composite semiconductor substrate with semiconductor elements bonded together at their bonding surfaces in which the interface of the bonded semiconductor elements contains no void. The substrate contains a first semiconductor element whose main surface serves as a first bonding surface and a second semiconductor element whose main surface serves as a second bonding surface. An insulating layer is selectively formed in a portion of the first bonding surface. The insulating layer recedes from the first bonding surface to be buried in the first semiconductor element. The first bonding surface is directly bonded to the second bonding surface except for the portion of the first bonding surface and a corresponding portion of the second bonding surface, thereby combining the first semiconductor element and the second semiconductor element with each other. The first semiconductor element is used for a semiconductor active layer where semiconductor devices are provided. A cavity is preferably generated between the insulating layer and the corresponding portion of the second bonding surface.

## Description

The present invention relates to a composite semiconductor substrate and more particularly, to a composite semiconductor substrate with semiconductor elements combined with each other that is effectively used for so-called power integrated circuits (ICs), and a fabrication method of the substrate.

In recent years, the wafer bonding technology has been increasingly used as a fabrication method of a composite semiconductor substrate with a multilayer structure such as the silicon-on-insulator (SOI) structure with the increasing improvement in adhesion or bonding properties. This technology enables to fabricate a variety of SOI-structured semiconductor substrates (SOI substrates).

The SOI substrate has already been put into practical use in power control devices with a high breakdown voltage. Also, the substrate of this sort had been expected to provide high-speed operation at a low supply voltage. Therefore, it has been attracting attention as a semiconductor substrate for the next-generation CMOS devices.

At present, in the application field of semiconductor power devices, to further increase the integration scale and reliability, so-called "intelligent power ICs", which include power devices with high-breakdown voltage and high-ON current and control circuit devices for controlling the power devices operable at a low supply voltage formed on the same semiconductor chip or substrate, are being vigorously developed.

To improve the driving current capacity of the power devices in such the intelligent power ICs, "a vertical power device" becomes necessary to be used. The vertical power device has a source and a gate formed on the same surface of the substrate as that on which the control circuit is formed, and a drain formed on the opposite surface of the substrate. In the intelligent power ICs with such the structure, a "partial SOI substrate" which allows the control circuit to be formed on the SOI structure is used. This partial SOI substrate of this sort was disclosed in the Japanese Non-Examined Patent publication No. 4-29353 published in 1992.

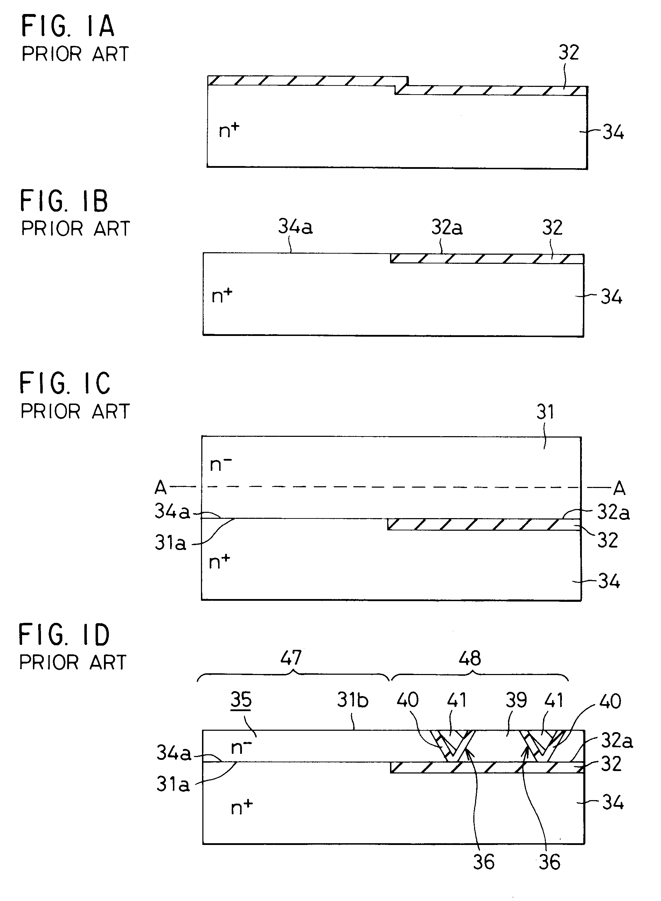

Figs. 1A to 1D show a process sequence of a conventional fabrication method of an SOI substrate disclosed in the Japanese Non-Examined Patent publication No. 4-29353. Hereafter, this method is referred to as a first conventional method.

First, a photoresist film (not shown) of a desired pattern is formed by a photolithography process on a main surface of an n⁺-type single-crystal silicon (Si) substrate 34. Then, using the patterned photoresist film as a mask, the main surface of the substrate 34 is selectively etched by an ion etching process, thereby forming a depressed area on the main surface. A small step is formed at the boundary of the depressed area and an undepressed area.

Next, the etched substrate 34 is thermally oxidized to form an insulating film 32 of SiO₂ on the main surface. The state at this stage is shown in Fig. 1A. The SiO₂ film 32 may be formed by a low-temperature chemical vapor deposition (CVD) process or other process.

Then, as shown in Fig. 1B, the insulating film 32 placed on the undepressed area of the main surface is selectively removed by a grinding/polishing process or an etching process, so that the exposed surface 34a of the n⁺-type single-crystal silicon substrate 34 is flush with the surface 32a of the remaining insulating film 32.

Subsequently, the surfaces 34a and 32a thus flattened are bonded onto a main surface 31a of an n⁻-type single-crystal silicon substrate 31, thereby bonding the two substrates 34 and 31 to each other. Then, the bonded substrates 34 and 31 are subjected to a heat-treatment to enhance the bonding strength. Thus, a composite substrate made of the firmly bonded substrates 34 and 31 is obtained as shown in Fig. 1C.

Next, to reduce the thickness of the n⁻-type single-crystal silicon substrate 31, the opposite side of the substrate 31 to the bonded main surface 31a is ground and polished. The resultant thickness of the substrate 31 is indicated by the A-A plane in Fig. 1C.

The remaining substrate 31 constitutes a single-crystal silicon active layer 35, as shown in Fig. 1D. Through this process, the exposed main surface 31b of the substrate 31 or active layer 35 is sufficiently planarized or flattened.

Thereafter, an insulating film 40 is formed on the flattened surface 31b and is patterned to a given plan shape by photolithography and etching processes. Using the patterned insulating film 40 as a mask, the active layer 35 is etched using an alkali etching solution, thereby forming a V-shaped isolation groove 36 in the active layer 35 at a position over the buried insulating film 32. Thus, a vertical power device formation region 47 and a control circuit device formation region 48 laterally isolated from each other are defined and at the same time, an island 39 of the single-crystal silicon active layer 35 is defined inside the control circuit device area 48 by the groove 36.

Then, by a thermal oxidation, low temperature CVD or other process, an insulating film 40 of SiO₂ or the like is formed on the surface 31b of the active layer 35. A polycrystalline silicon (polysilicon) layer 41 is formed on the insulating film 40 by a CVD process.

Thereafter, the polysilicon layer 41 and the insulating film 40 are removed by a grinding and/or polishing process or an etching process, so that the isolation groove 36 is buried with the remaining insulating film 40 and the remaining polysilicon layer 41. Thus, the composite or SOI-structured substrate including the device formation regions 47 and 48 electrically isolated from each other is obtained, as shown in Fig. 1D.

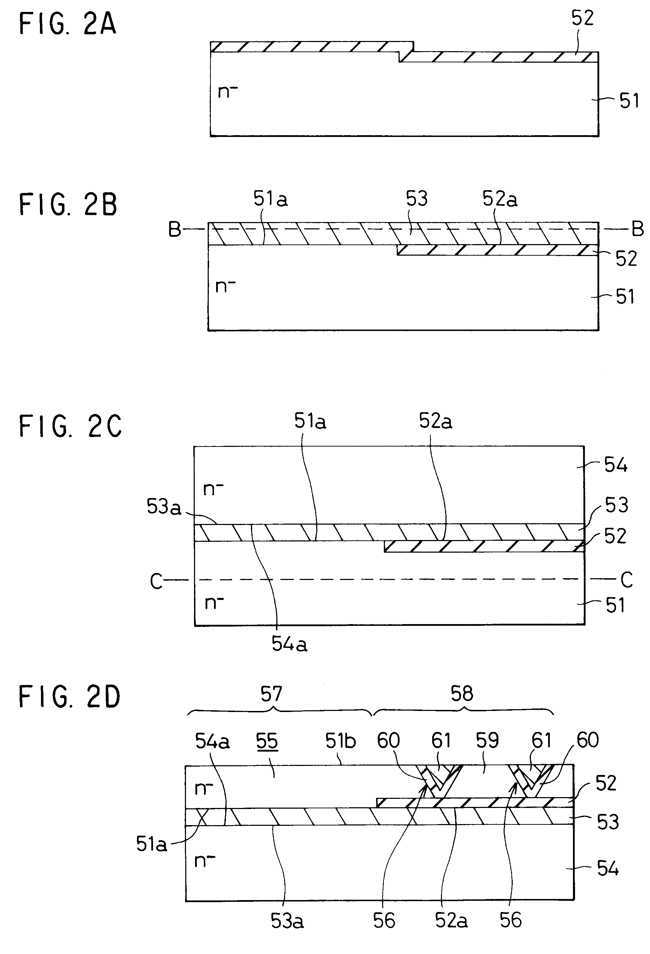

Figs. 2A to 2D show another conventional fabrication method of a composite semiconductor substrate, which was proposed in the Japanese Patent Application No. 6-156451 filed in 1994 (hereafter referred to as a second conventional method).

First, as shown in Fig. 2A, an SiO₂ film (not shown) with a uniform thickness is formed by a thermal oxidation process or other on a main surface of an n⁻-type single-crystal silicon substrate 51. The SiO₂ film is selectively removed (i.e., patterned) by photolithography and dry etching processes, thereby exposing a desired portion of the substrate 51.

Next, using the patterned SiO₂ film as a mask, the substrate 51 is etched to form a depressed area on the main surface of the substrate 51. A small step is formed at the boundary of the depressed area and an undepressed area.

Then, after removing the patterned SiO₂ film, an insulating film 52 with a uniform thickness is formed on the depressed main surface of the substrate 51, as shown in Fig. 2A.

Then, the insulating film 52 placed on the undepressed area of the main surface is selectively removed by a grinding/polishing or etching process or other, so that the exposed surface 51a of the n⁻-type single-crystal silicon substrate 51 is flush with the surface 52a of the remaining insulating film 52.

Subsequently, a polysilicon layer 53 is formed on the surfaces 51a and 52a thus flattened by a CVD process or other, as shown in Fig. 2B. The opposite side of the polysilicon layer 53 to the substrate 51 is then polished to provide a mirror surface 53a. The resultant thickness of the polysilicon layer 53 is indicated by the B-B plane in Fig. 2C.

The mirror surface 53a of the polysilicon layer 53 is bonded onto a main surface 54a of an n⁻-type single-crystal silicon substrate 54, thereby bonding the two substrates 54 and 51 to each other. Then, the bonded substrates 54 and 51 are subjected to a heat-treatment to enhance the bonding strength. Thus, a composite substrate made of the firmly bonded substrates 54 and 51 is obtained, as shown in Fig. 2 C.

Subsequently, to reduce the thickness of the single-crystal silicon substrate 51, the opposite side of the substrate 51 to the substrate 54 is ground and polished. The resultant thickness of the substrate 51 is indicated by the C-C plane in Fig. 2C.

The remaining substrate 51 constitutes a single-crystal silicon active layer 55, as shown in Fig. 2D. Through this process, the exposed main surface 51b of the substrate 51 is sufficiently planarized or flattened.

Thereafter, an insulating film (not shown) is formed on the flattened surface 51b and is patterned to a given shape by photolithography and etching processes. Using the patterned insulating film as a mask, the active layer 55 is etched using an alkali solution, thereby forming a V-shaped isolation groove 56 in the active layer 55 at a position over the buried insulating film 52. Thus, a vertical power device formation region 57 and a control circuit device formation region 58 laterally isolated from each other are defined and at the same time, an island 59 of the single-crystal silicon active layer 55 is defined inside the control circuit device formation region 58.

Then, by a thermal oxidation, low temperature CVD or other process, an insulating film 60 of SiO₂ or the like is formed on the surface 51b of the active layer 51. A polysilicon layer 61 is formed on the insulating film 60 by a CVD process.

Thereafter, the polysilicon layer 61 and the insulating film 60 are removed by a grinding and/or polishing process or an etching process, so that the isolation groove 56 is buried with the remaining insulating film 60 and the remaining polysilicon layer 61. Thus, the composite or SOI-structured substrate including the device formation regions 67 and 68 electrically isolated from each other is obtained, as shown in Fig. 2D.

With the above first conventional method of Figs. 1A to 1D, the surface 34a of the single-crystal silicon substrate 34 and the surface 32a of the insulating film 32 are bonded onto the bonding surface 31a of the single-crystal silicon substrate 31. When the surfaces 34a and 32a made of dissimilar materials are flattened, it is extremely difficult to hold the surface unevenness to a level of 10 nm or less with the polishing or etching technology now available. This causes insufficient flatness of the bonding surface of the substrate 34, leading to occurrence of voids (portions not bonded) on the boding surface. This results in peeling off in the void areas in the subsequent heat treatment processes, which raises a problem of the vertical power device becoming inoperative.

With the second conventional method of Figs. 2A to 2D, since the polysilicon film 53 with the flattened surface 53a is formed on the bonding surface of the substrate 51, voids are difficult to occur. However, additional processes are necessary for forming and polishing the polysilicon layer 53, which results in a drawback of a higher fabrication cost.

Accordingly, an object of the present invention is to provide a composite semiconductor substrate having semiconductor elements bonded together at their bonding surfaces in which the interface of the bonded semiconductor elements contains no void.

Another object of the present invention is to provide a fabrication method of the above composite semiconductor substrate without increasing the number of necessary process steps.

A further object of the present invention is to provide a composite semiconductor substrate having semiconductor elements bonded together at their bonding surfaces that enables to monolithicaly integrate vertical power devices and control circuit devices therefor on the same semiconductor substrate, and a fabrication method thereof.

The above object together with others not specifically mentioned will become clear to those skilled in the art from the following description.

According to a first aspect of the present invention, a composite semiconductor substrate is provided, which has a first semiconductor element whose main surface serves as a first bonding surface and a second semiconductor element whose main surface serves as a second bonding surface.

An insulating layer is selectively formed in a portion of the first bonding surface. The insulating layer recedes from the first bonding surface to be buried in the first semiconductor element.

The first bonding surface is directly bonded to the second bonding surface except for the portion of the first bonding surface and a corresponding portion of the second bonding surface, thereby combining the first semiconductor element and the second semiconductor element with each other.

With the composite semiconductor substrate according to the first aspect of the invention, the first bonding surface is directly bonded to the second bonding surface except for the portion of the first bonding surface where the insulating layer is selectively formed and the corresponding portion of the second bonding surface, thereby combining the first semiconductor element and the second semiconductor element with each other.

Also, the insulating layer recedes is formed to recede from the first bonding surface to be buried in the first semiconductor element. In other words, the insulating layer is not contacted with the second bonding surface.

Therefore, the first bonding surface can be planarized or flattened satisfactorily, in other words, the first bonding surface can have a sufficient flatness. As a result, no voids are generated at the interface of the combined first semiconductor element and the second semiconductor element.

Additionally, if a vertical power device is formed on the first semiconductor element in an area excluding the insulating layer and a control device for the power device is formed on the first semiconductor element in an area including the insulating layer, there arises no possibility of degradation of the vertical power device. This means that a plurality of vertical power devices and a plurality of control circuit devices therefor can be monolithicaly integrated on the same semiconductor substrate.

Typically, the first semiconductor element is used for a semiconductor active layer where semiconductor devices are provided.

In a preferred embodiment of the first aspect, a cavity is generated between the insulating layer and the corresponding portion of the second bonding surface.

In another preferred embodiment of the first aspect, the first semiconductor element and the second semiconductor element are of a single-crystal structure.

According to a second aspect of the present invention, a fabrication method of a composite semiconductor substrate is provided, which includes the following steps.

A first semiconductor element whose main surface serves as a first bonding surface and a second semiconductor element whose main surface serves as a second bonding surface are prepared.

An insulating layer is selectively formed in a portion of the first bonding surface. The insulating layer recedes from the first bonding surface to be buried in the first semiconductor element.

The second bonding surface is then bonded onto the first bonding surface to thereby combine the first semiconductor element and the second semiconductor element with each other. The insulating layer is opposed to and separated from the second bonding surface.

With the fabrication method of the second aspect of the invention, after the selective formation of the insulating layer receding from the first bonding surface to be buried in the first semiconductor element, the second bonding surface is bonded onto the first bonding surface, thereby combining the first semiconductor element and the second semiconductor element with each other.

Therefore, the first bonding surface can be planarized or flattened satisfactorily and as a result, no semiconductor layer is additionally required between the first bonding surface and the second bonding surface in order to avoid any voids at the interface of the combined first semiconductor element and the second semiconductor element.

Accordingly, this method enables to realize the composite semiconductor substrate according to the first aspect without increasing the number of necessary process steps. This leads to reduction in fabrication cost.

In a preferred embodiment of the second aspect, the step of selectively forming the insulating layer includes the following steps (i) and (ii).

The step (i) is to selectively oxidize the first bonding surface to thereby produce an oxide film. The oxide film has a first part sinking into the first semiconductor element and a second part protruding from the first bonding surface.

The step (ii) is to selectively remove the oxide film so that the second part of the oxide film is entirely removed and the first part thereof is partially removed. The remaining oxide film recedes from the first bonding surface.

In another preferred embodiment of the second aspect, the step of bonding the first bonding surface onto the second bonding surface is performed in an oxygen-containing atmosphere, i.e., in oxygen or atmospheric air.

It is preferred that the first bonding surface and the second bonding surface are mirror-polished prior to the step of bonding the first bonding surface and the second bonding surface.

It is preferred that an opposite surface of the first semiconductor element to the first bonding surface is ground and/or polished to reduce the thickness of the first semiconductor element.

In order that the invention may be readily carried into effect, it will now be described with reference to the accompanying drawings.

Figs. 1A to 1D are partial cross-sectional views showing a conventional fabrication method of a composite semiconductor substrate, respectively.

Figs. 2A to 2D are partial cross-sectional views showing another conventional fabrication method of a composite semiconductor substrate, respectively.

Figs. 3A to 3G are partial cross-sectional views showing a fabrication method of a composite semiconductor substrate according to a first embodiment of the invention, respectively.

Fig. 4 is a partial plan view showing the fabrication method according to the first embodiment of the present invention, which corresponds to the state of Fig. 3A.

Fig. 5 is a partial plan view showing the fabrication method according to the first embodiment of the present invention, which corresponds to the state of Fig. 3G.

Figs. 6A and 6B are partial cross-sectional views showing a fabrication method of a composite semiconductor substrate according to a second embodiment of the invention, respectively.

Preferred embodiments of the present invention will be described in detail below while referring to the drawings attached.

### FIRST EMBODIMENT

In a fabrication method of a semiconductor device according to a first embodiment of the invention, the following process steps are performed. This embodiment is best suited for monolithically integrating vertical power devices and control circuit devices on a composite semiconductor substrate.

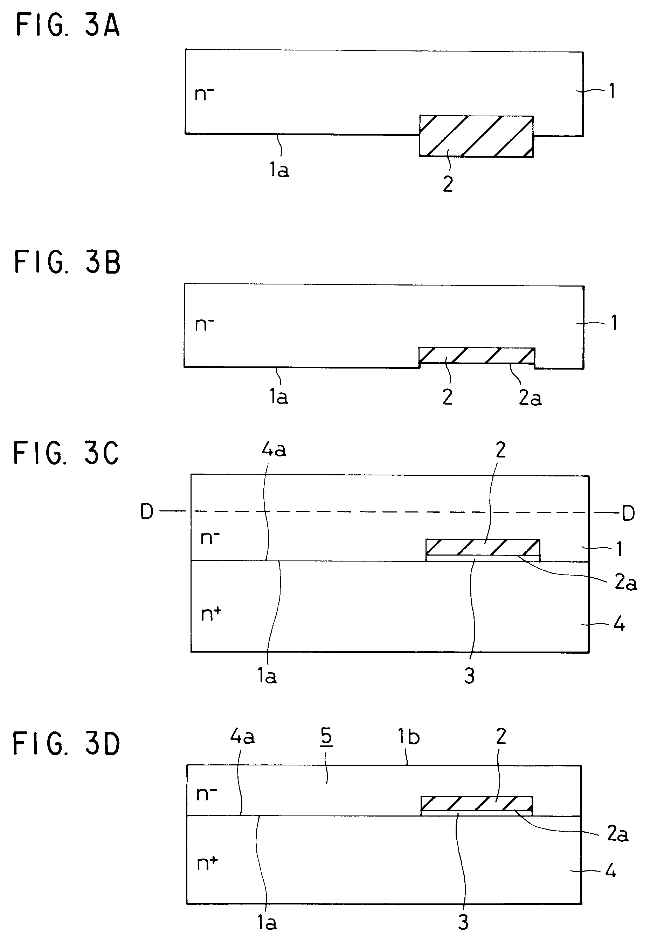

First, as shown in Fig. 3A, an n⁻-type single-crystal silicon substrate 1 is prepared. The substrate 1 has a diameter of 5 inches, a thickness of approximately 600 µm, and a resistivity of 1 Ω·cm.

Next, the substrate 1 is selectively oxidized using the LOCOS (Local Oxidation of Silicon) technique, producing an insulating film 2 of SiO₂ with a thickness of approximately 1 µm in a portion of a main surface 1a of the substrate 1. This LOCOS process is, for example, performed in a water vapor at a temperature of 1100 °C for 100 minutes.

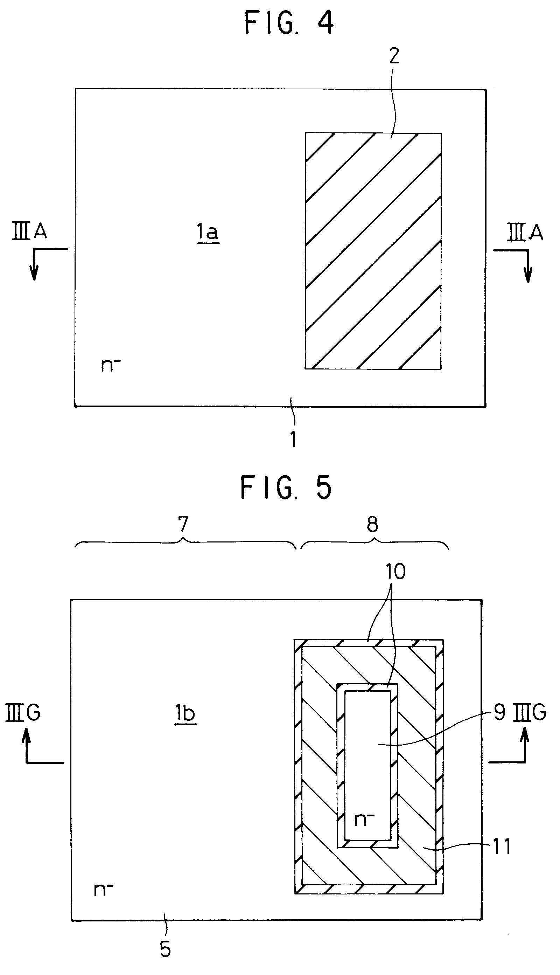

The insulating film 2 has a rectangular plan shape, as shown in Fig. 4. The upper part of the film 2 is buried in the substrate 1 and the lower part thereof is protruded from the main surface 1a serving as a bonding surface.

Then, the insulating film 2 is partially etched with the use of a buffered hydrogen fluoride (HF) as an etching solution, thereby reducing the thickness of the film 2 from approximately 2 µm to 0.8 µm. Thus, the surface 2a of the insulating film 2 is lower than the bonding surface 1a of the substrate 1, as shown in Fig. 3B.

On the other hand, an n⁺-type single-crystal silicon substrate 4 having a diameter of 5 inches, a thickness of approximately 600 µm, and a resistivity of 0.01 to 0.02 Ω·cm is prepared. A main surface 1a of the substrate 4 serving as a bonding surface is then bonded onto the bonding surface 1a of the substrate 1 in the atmospheric air at room temperature, as shown in Fig. 3C. The bonding process may be performed in an oxygen atmosphere.

Subsequently, the bonding surface 4a of the n⁺-type single-crystal silicon substrate 4 and the bonding surface 1a of the n⁻-type single-crystal silicon substrate 1 in which the insulating film 2 is buried are opposed to each other, thereby bonding the surfaces 1a and 4a to each other.

Thereafter, to increase the bonding strength between the surfaces 1a and 4a, the substrates 1 and 4 thus bonded are subjected to a heat-treatment at a temperature of 1100 to 1200 °C for approximately 2 hours.

At this stage, as shown in Fig. 3C, a cavity 3 of 0.2 µm in thickness is generated between the opposed surfaces 2a and 4a. The cavity has a rectangular plan shape corresponding to that of the insulating film 2. The thickness of the cavity can be readily controlled by adjusting the etching depth or amount of the film 2.

It is sufficient for the invention that the thickness of the cavity 3 is 0.5 µm or less. If this thickness is over 0.5 µm, it is difficult for the insulating film 2 to be etched or depressed while keeping the thickness of the film 2 at a specified level. If this thickness is 0 µm, the surface 2a of the insulating film 2 is contacted with the bonding surface 4a and as a result, the same problem as that of the first conventional method tends to occur.

Thereafter, the n⁻-type silicon substrate 1 is ground using a grinder and then polished using a polishing agent to have a desired thickness as indicated by the D-D plane in Fig. 3C, obtaining an exposed, flattened surface 1b, as shown in Fig. 3D. The remaining silicon substrate 1 on the substrate 4 constitutes a single-crystal silicon active layer 5.

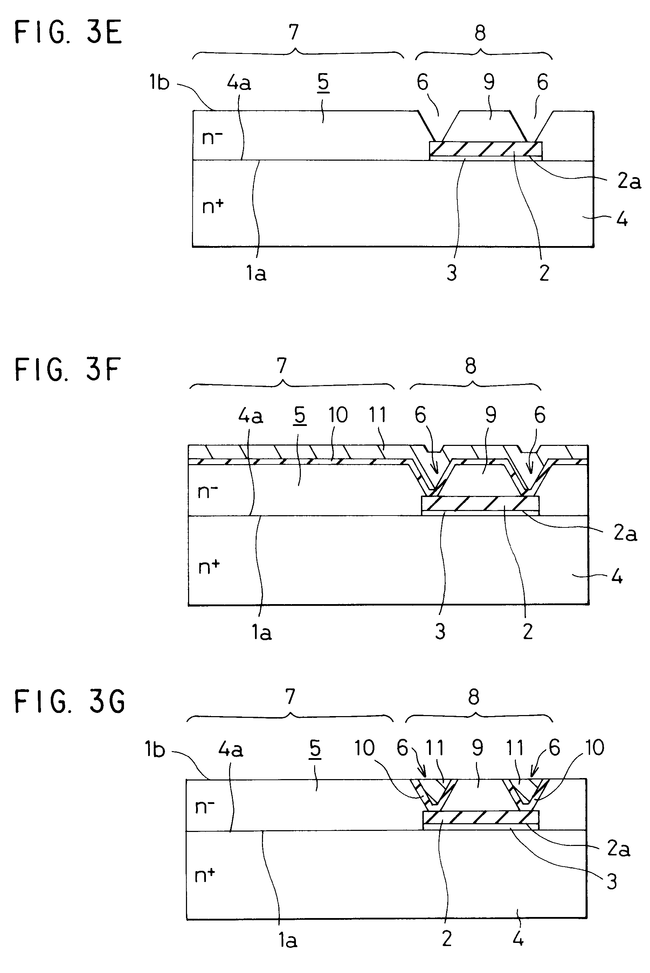

An SiO₂ film (not shown) with a uniform thickness is formed on the active layer 5 by a thermal oxidation, CVD, or other process. The SiO₂ film is then patterned to remove its, unnecessary portion. A V-shaped isolation groove 6 is formed in the active layer 5 using the patterned silicon oxide film as a mask by a wet etching process using an alkali etching solution such as a KOH solution or a reactive ion etching (RIE) process, as shown in Fig. 3E. The patterned, masking SiO₂ film is then removed.

The groove 6 is placed in a portion of the active layer that is positioned over the buried insulating film 2, defining a vertical power device formation region 7 and a control circuit device formation region 8. The regions 7 and 8 are laterally isolated from each other by the groove 6. An island 9 of the single-crystal silicon layer 5 is defined inside the control circuit device formation region 8 by the groove 6. The bottom of the groove 6 reaches the buried insulating film 2. The insulating film 2 serves as an etching stop during the etching process for the groove 6.

Then, as shown in Fig. 3F, by a thermal oxidation, low-temperature CVD or other process, an insulating film 10 made of SiO₂ is formed on the entire surface 1a of the substrate 1, which is followed by the formation of a polysilicon layer 11 on the insulating film 10 to cover the isolation groove 6 using a CVD process.

The polysilicon layer 11 and the insulating film 10 formed on the substrate 1 are removed by a grinding and/or polishing process or an etching process. Thus, the remaining insulating film 10 and the remaining polysilicon film 11 in the groove 6 bury the groove 6 itself, resulting in a composite or SOI-structured substrate including the device formation regions 7 and 8 which are electrically isolated from each other, as shown in Figs. 3G and 5.

With the composite semiconductor substrate according to the first embodiment, the bonding surface 1a of the substrate 1 is directly bonded to the bonding surface 4a of the substrate 4 except for the portion of the bonding surface 1a where the buried insulating layer 2 exists and the corresponding portion of the bonding surface 4a, thereby combining the single-crystal silicon substrates 1 and 4 with each other.

Also, the insulating layer 2 recedes from the bonding surface 1a to be buried in the substrate 1. In other words, the insulating layer 2 is not contacted with the bonding surface 4a.

Therefore, the bonding surface 1a can be planarized or flattened satisfactorily and as a result, no voids are generated at the interface of the combined semiconductor substrates 1 and 4.

Additionally, since the vertical power device formation region 7 is placed in the area where the bonding surfaces 1a and 4a of the substrates 1 and 4 are directly bonded to each other, there arises no possibility of degradation of the vertical power device. This means that a plurality of vertical power devices and a plurality of control circuit devices therefor can be monolithicaly integrated on this composite silicon substrate, which offers highly reliable power ICs.

### SECOND EMBODIMENT

A fabrication method of a semiconductor device according to a first embodiment has the same process steps as those in the first embodiment except that a p⁺-type ion-implantation region 12 is formed in place of the V-groove 6. Therefore, the description relating to the same process steps is omitted here for the sake of simplification by attaching the same reference numerals to the corresponding elements or members. Consequently, the method according to the second embodiment can provide the same advantages as those in the first embodiment.

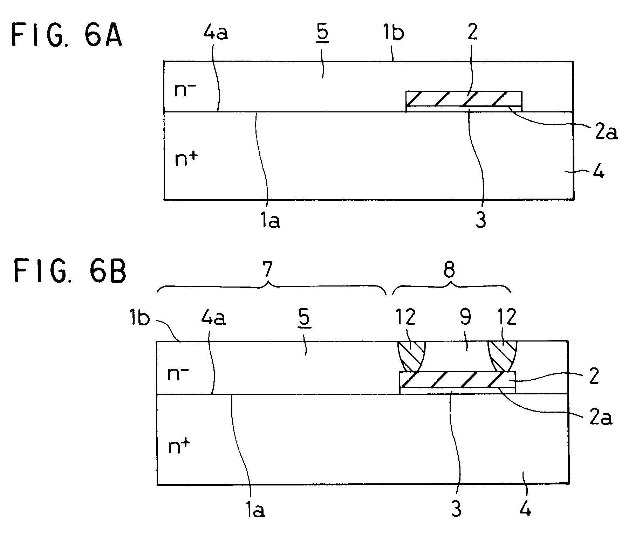

Through the same processes (as shown in Figs. 3C and 3D) as those in the first embodiment, the structure as shown in Fig. 6A is obtained. In Fig. 6, the single-crystal silicon layer 5 is formed.

Next, a patterned photoresist film (not shown) is formed on the active layer 5 by a photolithography process. Then, boron (B) is selectively ion-implanted into the active layer 5 at a dose of 4 x 10¹⁵ to 1 x 10¹⁶ using the patterned photoresist film as a mask, forming a p⁺-type isolation region 12 at a position over the insulating film 2, as shown in Fig. 6B. The bottom of the isolation region 12 is contacted with the insulating film 2.

Thus, the vertical power device formation region 7 and the control circuit device region 8 are laterally isolated from each other and at the same time, the single crystal silicon islands 9 is defined by the p⁺-type isolation region 12.

The method according to the second embodiment is applicable to the fields where the isolation resistance between the vertical power device formation region 7 and the control circuit device region 8 may be at a low level. Since this method can eliminate the need for the formation processes of the isolation groove 6 as is the case with the first embodiment, there is an additional advantage of simplification in the process sequence.

In the above embodiments, two substrates are combined with each other. However, the invention is not limited thereto and three or more substrates may be combined as semiconductor elements.

While the preferred forms of the present invention have been described, it is to be understood that modifications will be apparent to those skilled in the art without departing from the spirit of the invention. The scope of the invention, therefore, is to be determined solely by the following claims.

## Claims

1. A composite semiconductor substrate comprising:
a first semiconductor element whose main surface serves as a first bonding surface;
a second semiconductor element whose main surface serves as a second bonding surface; and
an insulating layer selectively formed in a portion of said first bonding surface, said insulating layer receding from said first bonding surface to be buried in said first semiconductor element;
wherein said first bonding surface is directly bonded to said second bonding surface except for said portion of said first bonding surface and a corresponding portion of said second bonding surface, thereby combining said first semiconductor element and said second semiconductor element with each other.

2. The substrate as claimed in claim 1, wherein said first semiconductor element is used for a semiconductor active layer where semiconductor devices are provided.

3. The substrate as claimed in claim 1 or 2, wherein a cavity is generated between said insulating layer and said corresponding portion of said second bonding surface.

4. The substrate as claimed in any of claims 1 to 3, wherein said first semiconductor element and said second semiconductor element are of a single-crystal structure.

5. The substrate as claimed in any of claims 1 to 4, wherein said first semiconductor element contains a first device formation region where a vertical power device is formed and a second device formation region where a control device for controlling said vertical power device is formed;
and wherein said first device formation region is placed in an area excluding said insulating layer, and said second device formation region is placed in an area including said insulating layer.

6. A fabrication method of a composite semiconductor substrate comprising the steps of:
(a) preparing a first semiconductor element whose main surface serves as a first bonding surface and a second semiconductor element whose main surface serves as a second bonding surface;
(b) selectively forming an insulating layer in a portion of said first bonding surface, said insulating layer receding from said first bonding surface to be buried in said first semiconductor element; and
(c) bonding said second bonding surface onto said first bonding surface to thereby combine said first semiconductor element and said second semiconductor element with each other;
wherein said insulating layer is opposed to and separated from said second bonding surface.

7. The method as claimed in claim 6, wherein said step (b) of selectively forming said insulating layer includes the following steps (i) and (ii);
and wherein said step (i) is to selectively oxidize said first bonding surface to thereby produce an oxide film, said oxide film having a first part sinking into said first semiconductor element and a second part protruding from said first bonding surface;
and wherein said step (ii) is to selectively remove said oxide film so that said second part of said oxide film is entirely removed and said the first part thereof is partially removed, said remaining oxide film receding from said first bonding surface.

8. The method as claimed in claim 6 or 7, wherein said step (c) of bonding said first bonding surface onto said second bonding surface is performed in an oxygen-containing atmosphere, i.e., in oxygen or atmospheric air.

9. The method as claimed in any of claims 6 to 8, further comprising a mirror-polishing step of said first bonding surface and a mirror-polishing step of said second bonding surface, which is performed prior to said step (c) of bonding said first bonding surface and said second bonding surface.

10. The method as claimed in any of claims 6 to 9, further comprising a step of grinding or polishing an opposite surface of said first semiconductor element to said first bonding surface to reduce a thickness of said first semiconductor element.

11. The method as claimed in any of claims 6 to 10, further comprising a step of forming a first device formation region where a vertical power device is formed and a second device formation region where a control device for controlling said vertical power device is formed in said first semiconductor element, which is performed after said step (c) of bonding said first bonding surface and said second bonding surface.
wherein said first device formation region is placed in an area excluding said insulating layer, and said second device formation region is placed in an area including said insulating layer.
